# EUROPÄISCHE PATENTANMELDUNG

(11) **EP 0 964 518 A2**
(43) Veröffentlichungstag der Anmeldung: **15.12.1999**
(21) Anmeldenummer: 99109458.2
(22) Anmeldetag: 11.05.1999
(51) Int. Cl.: H03K 17/945

(54) **Verfahren zur Einstellung von elektronischen Nährungsschaltern**

(30) Priorität: 20.05.1998 DE 19822744
(71) Anmelder: SIEMENS AKTIENGESELLSCHAFT, 80333 München (DE)
(72) Erfinder: Lechner, Stefan, 81369 München (DE); Luber, Ernst, 92259 Neukirchen (DE); Scheibel, Klaus, 92263 Ebermannsdorf (DE)

(57) **Zusammenfassung**

Bei einem elektronischen Näherungsschalter (1), insbesondere einem Ultraschall-Näherungsschalter, mit einer Überstrom-Überwachungseinrichtung (8), mit einem Potentiometer (10) zur Einstellung einer Schaltgrenze von außen und mit einem auf beide zugreifenden Mikroprozessor (14) sollen Schaltgrenzen eingelernt werden. Hierzu werden ein am Schaltausgang (7) simulierter Überstrom und die gleichzeitige Einstellung des Potentiometers (10) in eine seiner beiden Einstellungen als Einlernbedingungen gewählt, bei denen der jeweils auftretende Meßobjekt-Abstand als Schaltgrenze im Mikroprozessor (14) gespeichert wird.

## Beschreibung

Die Erfindung bezieht sich auf ein Verfahren zum Laden von Betriebsparametern in einen mit einer Überstrom-Überwachungseinrichtung versehenen Näherungsschalter, der ein von außen einstellbares Potentiometer, einen Lastanschluß und ein zu diesem in Reihe liegendes Schaltelement, sowie einen Mikroprozessor aufweist, der einen am Lastanschluß simulierten Überstrom erfaßt.

Ein gattungsgemäßes Verfahren ist aus der EP 0 519 089 B1 bekannt. Bei diesem Verfahren wird eine nur für den Überstromfall vorgesehene Schutzeinrichtung zur Dateneingabe von Betriebsparametern verwendet. Dabei wird mit Hilfe eines Programmiergeräts am Lastanschluß ein Kurzschluß simuliert, während ein als Schaltausgang des Näherungsschalters verwendeter Transistor durchgeschaltet ist. Die als Betriebsdaten einem Mikroprozessor zugeführten Impulse werden durch Synchronisierimpulse an einem Freigabeeingang des Näherungsschalters synchronisiert. Das Impulsraster dient zur Erkennung von Programm- und Auslesezyklen.

Bei elektronischen Ultraschall-Näherungsschaltern sind üblicherweise die Schaltgrenzen einstellbar, d.h. Entfernungen, bei denen der Ausgang oder mehrere Ausgänge schalten. Bekannt ist die direkte Einstellung über ein Potentiometer, das ohne Öffnung des Gehäuses von außen einstellbar ist, oder das Einlernen von Schaltgrenzen. Beide Einstellarten sind mit verschiedenen Vor- und Nachteilen behaftet. Zur Realisierung verschiedener Einstellungen werden z.B. zusätzliche Bedienelemente im Näherungsschalter integriert.

Bei der Lösung mit dem Potentiometer erfolgt die Einstellung über eine Einstellschraube, deren Schlitzstellung zugleich als Anzeige des Einstellwerts dient. Hierdurch ist jedoch nur eine Grobeinstellung ohne einen Reflektor möglich. Ein versehentliches Verstellen der Einstellschraube ist nicht ausgeschlossen.

Weiterhin ist es bekannt, über einen gesonderten Lerneingang am Näherungsschalter Schaltgrenzen einzulernen. Allerdings ist ein solcher Zusatzeingang nicht geformt und benötigt zusätzlichen Schaltungs- und Raumbedarf, ganz abgesehen von der damit verbundenen erhöhten EMV-Empfindlichkeit.

Daher liegt der Erfindung die Aufgabe zugrunde, ein Verfahren der obengenannten Art dahingehend zu verbessern, daß ein einfaches Einlernen von Schaltgrenzen möglich ist.

Die Aufgabe wird dadurch gelöst, daß die beiden Endstellungen des Potentiometers in Verbindung mit dem simulierten Überstromzustand am Lastanschluß den Mikroprozessor als Einlernbedingungen dienen, bei denen ein erster und/oder zweiter erfaßter Meßobjekt-Abstand als erste und/oder zweite Schaltgrenze im Näherungsschalter abgespeichert wird. Damit ist neben der Einstellung über ein eingebautes Potentiometer auch das Einlernen von Schaltgrenzen ohne zusätzlichen Hardware-Aufwand möglich. Zur Einstellung genügt ein Taster, mit dem der Lastanschluß niederohmig geschaltet wird, um den erforderlichen Überstrom zu simulieren. Die Nutzung bestimmter Potentiometer-Einstellungen dient als Auswahlkriterium für bestimmte Einstellwerte, z.B. die erste oder zweite Schaltgrenze.

Eine besonders vorteilhafte Weiterbildung des Verfahrens besteht, wenn die erste und/oder zweite Schaltgrenze in einem Festwertspeicher des Mikroprozessors abgespeichert wird.

Weiterhin ist es vorteilhaft, wenn der simulierte Überstrom-Zustand am Lastanschluß nur in Verbindung mit einem erfaßten Objekt auftritt, wobei das Schaltelement geschlossen ist. Somit kann das Einlernen nur ausgelöst werden, wenn ein Objekt im Erfassungsbereich ist.

Außerdem ist es von Vorteil, wenn der Näherungsschalter als Ultraschall-Vierdraht-Näherungsschalter ausgeführt ist, mit einem Versorgungsanschluß, einem Masseanschluß, dem Lastanschluß sowie einem Freigabeanschluß. Dies ist eine üblicherweise anzutreffende, genormte Ausführungsform.

Bei Vorhandensein eines Freigabeanschlusses zu Synchronierzwecken wird dieser zweckmäßigerweise niederohmig angeschlossen. Hierdurch wird dem Mikroprozessor zusätzlich der Einlernmodus angezeigt.

Ein Ausführungsbeispiel der Erfindung wird im folgenden anhand einer Zeichnung näher erläutert.

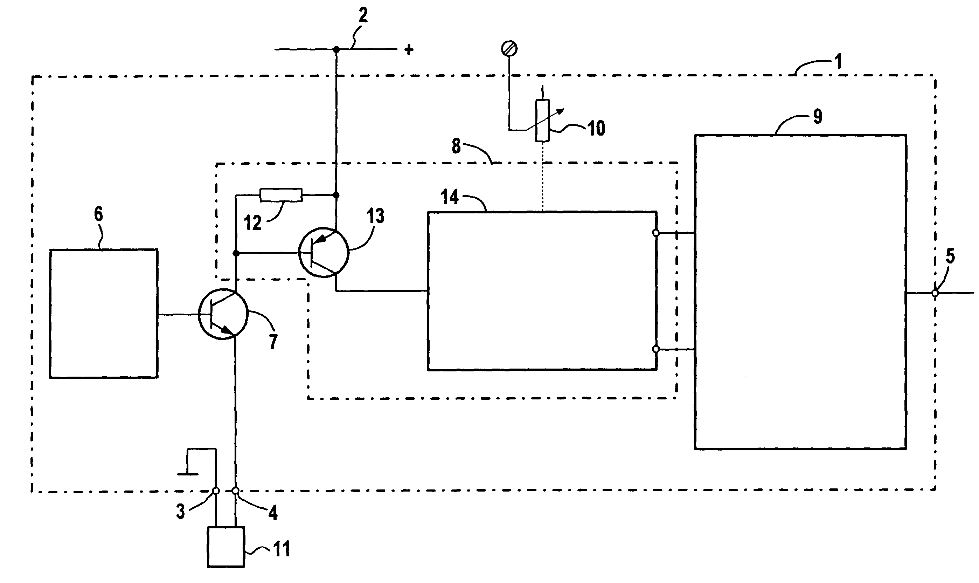

Die Figur zeigt einen Vierdraht-Näherungsschalter 1 mit genormten Anschlüssen, einen Versorgungsanschluß 2, einen Masseanschluß 3, einen Lastanschluß 4 und einen Freigabe- bzw. Synchronisieranschluß 5.

Der Näherungsschalter 1, der z.B. als Ultraschall-Näherungsschalter ausgeführt sein kann, weist einen Sensor 6, einen nachgeschalteten Schaltausgang 7, der hier durch einen Transistor als Schaltelement realisiert ist, zu dem der Lastanschluß 4 in Reihe liegt, eine Überstromeinrichtung 8, eine Synchronisiereinrichtung 9 sowie ein von außen am Näherungsschalter 1 einstellbares Potentiometer 10 auf. Mit diesem ist die Grobeinstellung einer Schaltgrenze des Näherungsschalters 1 möglich. Zwischen den Lastanschluß 4 und den Masseanschluß 3 ist hier zum Einlernen von Schaltgrenzen, abweichend vom üblichen Lastbetrieb, ein Taster 11 geschaltet. Zwischen dem Transistor 7 und dem Versorgungsanschluß 2 liegt ein Stromfühlerwiderstand 12, zu dem die Basis-Emitter-Strecke eines weiteren Transistors 13 parallel liegt, dessen Kollektor an einen Mikroprozessor 14 geführt ist. Der Stromfühlerwiderstand 12, der Transistor 13 und der Mikroprozessor 14 gehören zur Überstromeinrichtung 8. Der Mikroprozessor 14 steht mit der Synchronisiereinrichtung 9 in Verbindung, die den Synchronisieranschluß 5 umfaßt. Der Mikroprozessor 14 greift in einer hier nicht näher dargestellten Weise auf den Einstellwert des Potentiometers 10 zu.

Im folgenden wird die Funktion der Überstromeinrichtung 8 und das hieraus abgeleitete Verfahren zum Einlernen zweier Schaltgrenzen beschrieben.

Sobald der Sensor 6 ein Objekt erfaßt, d.h., daß ein Echosignal empfangen wird, schaltet der Transistor 7 durch. Durch gleichzeitiges Drücken des Tasters 11 wird ein Überstrom simuliert, der ähnlich einem Lastkurzschluß von der Überstromeinrichtung 8 erfaßt wird. Der den Stromfühlerwiderstand 12 durchfließende Überstrom steuert den weiteren Transistor 13 durch, so daß über den Versorgungsanschluß 2 ein Spannungsimpuls zum Mikroprozessor 14 durchgeschaltet wird. Dabei ist zugleich das Potentiometer 10 in eine seiner beiden Endstellungen, Minimum oder Maximum bzw. Links-Anschlag oder Rechts-Anschlag, eingestellt. Die vorgenannten Bedingungen dienen als Eingabe- bzw. Einlernbedingungen für den Mikroprozessor 14, bei denen der jeweils erfaßte Meßobjektabstand als Schaltgrenze festgehalten, d.h. zum Beispiel in einem Festwertspeicher des Mikroprozessors 14 abgespeichert wird. Dabei kann beim Links-Anschlag des Potentiometers 10 die erste Schaltgrenze und beim Rechts-Anschlag die zweite Schaltgrenze eingelesen werden oder umgekehrt. Weist der Näherungsschalter 1 wie bei der vorliegenden Ausführungsform zusätzlich einen Synchronisieranschluß 5 zur Synchronisation mit benachbart betriebenen Näherungsschaltern auf, erweist es sich zum Einlernen der Schaltgrenzen als zweckmäßig, mit dem obengenannten Taster 11 nicht nur den Lastanschluß 4, sondern zugleich auch den Synchronisieranschluß 5 auf Masse zu legen. Hierdurch erhält der Mikroprozessor 14 zusätzlich die Information zum Wechsel in den Einlernmodus, d.h. das Teach-In.

Das Teach-In wird hier also durch gleichzeitiges Verbinden des Schaltausgangs 7 sowie des Synchronisieranschlusses 5 mit der Masse, über den Masseanschluß 3 ausgelöst.

Bedingt durch die Struktur des Schaltausgangs, d.h. Einsatz eines PNP-Transistors 7, kann ein Kurzschluß- oder Überstrom nur dann auftreten und ausgewertet werden, wenn der Schaltausgang 7 aktiv, d.h. leitend ist. Dies ist nur dann der Fall, wenn der maximale Erfassungsbereich bei entsprechender Endstellung des Potentiometers 10 eingestellt ist und wenn sich ein Objekt im Erfassungsbereich befindet. Das Teach-In kann somit nur ausgelöst werden, wenn ein Objekt im Erfassungsbereich ist.

Der Übergang vom eingelernten Wert zum frei einstellbaren Wert über das Potentiometer 10 erfolgt dadurch, daß das Potentiometer 10 aus seiner einen Endstellung während des Teach-In heraus auf einen neuen Wert eingestellt wird. Da die Einstellung des Potentiometers 10 während des Teach-In vom Mikroprozessor 14 mit abgespeichert wurde, kann er diese Veränderung einfach erkennen. Somit ist auf einfache Weise der Wechsel vom Teach-In-Betrieb in den Einstellungs-Betrieb mit dem Potentiometer 10 möglich.

## Patentansprüche

1. Verfahren zum Laden von Betriebsparametern in einen mit einer Überstrom-Überwachungseinrichtung (8) versehenen Näherungsschalter (1), der ein von außen einstellbares Potentiometer (10), einen Lastanschluß (4) und ein zu diesem in Reihe liegendes Schaltelement (7) sowie einen Mikroprozessor (14) aufweist, der einen am Lastanschluß (4) simulierten Überstrom erfaßt, **dadurch gekennzeichnet,** daß die beiden Endstellungen des Potentiometers (10) in Verbindung mit dem simulierten Überstrom-Zustand am Lastanschluß (4) den Mikroprozessor (14) als Einlernbedingungen dienen, bei denen ein erster und/oder zweiter erfaßter Meßobjekt-Abstand als erste und/oder zweite Schaltgrenze im Näherungsschalter (1) abgespeichert wird.

2. Verfahren nach Anspruch 1, **dadurch gekennzeichnet,** daß die erste und/oder zweite Schaltgrenze in einem Festwertspeicher des Mikroprozessors (14) abgespeichert wird.

3. Verfahren nach Anspruch 1 oder 2, **dadurch gekennzeichnet,** daß der simulierte Überstrom-Zustand am Lastanschluß (4) nur in Verbindung mit einem erfaßten Objekt auftritt, wobei das Schaltelement (7) geschlossen ist.

4. Verfahren nach einem der vorangehenden Ansprüche, **dadurch gekennzeichnet,** daß der Näherungsschalter als Ultraschall-Vierdraht-Näherungsschalter (1) ausgeführt ist, mit einem Versorgungsanschluß (2), einem Masseanschluß (3), dem Lastanschluß (4) sowie einem Freigabeanschluß (5).

5. Verfahren nach Anspruch 4, **dadurch gekennzeichnet,** daß der Freigabeanschluß (5) niederohmig angeschlossen ist.
